Europäisches Patentamt

European Patent Office

Office européen des brevets

(11) Publication number: **0 177 141**
**A2**

## (12) EUROPEAN PATENT APPLICATION

(21) Application number: **85305667.9**

(22) Date of filing: **09.08.85**

(51) Int. Cl.⁴: **H 01 S 3/19**

(30) Priority: **22.09.84 GB 8424045**

(43) Date of publication of application:
**09.04.86 Bulletin 86/15**

(84) Designated Contracting States:
**AT BE CH DE FR IT LI LU NL SE**

(71) Applicant: **STANDARD TELEPHONES AND CABLES
PUBLIC LIMITED COMPANY
190 Strand
London, WC2R 1DU(GB)**

(72) Inventor: **Greene, Peter David
23 Old Orchard Harlow
Essex(GB)**

(74) Representative: **Capsey, Sydney Ross
Standard Telephones and Cables Patent Department
Edinburgh Way
Harlow Essex CM20 2SH(GB)**

(54) **Semiconductor lasers.**

(57) In order to narrow the far field of the light output from a multilayer semiconductor laser structure in a direction perpendicular to the layers, whilst maintaining a high confinement factor, a thin layer (6, 7) is interposed between the active layer (1) and a conventional light confining layer (4, 5). The thin layer is of a lower refractive index than the light confining layer, which in turn is of a lower refractive index than the active layer.

## SEMICONDUCTOR LASERS

This invention relates to semiconductor lasers.

Many semiconductor laser structures, for example the IRW (Inverted Rib Waveguide) laser, have asymmetrical near and far fields.  A typical far field has a full width at half maximum power (FWHM) of approximately $40^{\circ}$ in the direction perpendicular to the layers of the laser structure, but only approximately $10^{\circ}$ in the direction parallel to the layers.  A more symmetrical field is desirable for more efficient coupling to optical fibres. As a general rule a narrow far field is associated with a wide near field, and vice versa.

A well established technique for widening the vertical near field and narrowing the vertical far field is the incorporation of layers of intermediate refractive index adjacent to the active layer.  Such structures are known as LGR (localised gain region) or SCH (separate confinement heterostructure) structures.

Fig. 2 shows the refractive index profile (dashed line) of a simple known laser structure comprising a high refractive index active layer 1 disposed between two layers 2 and 3, of lower refractive index.  The solid line indicates the related light distribution.  Fig. 3 shows the profile and distribution for a known LGR/SCH structure, the intermediate refractive index layers 4 and 5 are of differing conductive type, layer 4 being of the same conductivity type as layer 2.  The aim of such structures is to achieve confinement of the injected electrons and holes within the active layer, but to allow a significant fraction of the light to be contained in the adjacent layers. However, with less confinement of light within the active layer, more gain per unit volume is required within the active layer. If the maximum gain is limited by gain saturation, it becomes difficult for the laser to function satisfactorily.

According to the present invention there is provided a semiconductor laser characterised a layer structure including an active layer, a first layer for confining light to the active layer and a further layer, the further layer being disposed between the active layer and the first light confining layer, the refractive index of the first light confining layer being less than that of the active layer and the refractive index of the further layer being less than that of the first light confining layer.

In the accompanying drawings

Fig. 1 illustrates the refractive index profile of a laser structure according to an embodiment of the present invention and the related light distribution;

Fig. 2 illustrates the refractive index profile of a known simple laser structure and the related light distribution;

Fig. 3 illustrates the refractive index profile of another known laser structure and the related light distribution;

Fig. 4 shows a cross-section through a laser structure according to an embodiment of the present invention, and

Fig. 5 illustrates the refractive index profile of the laser structure whose parameters are quoted in Table I herein.

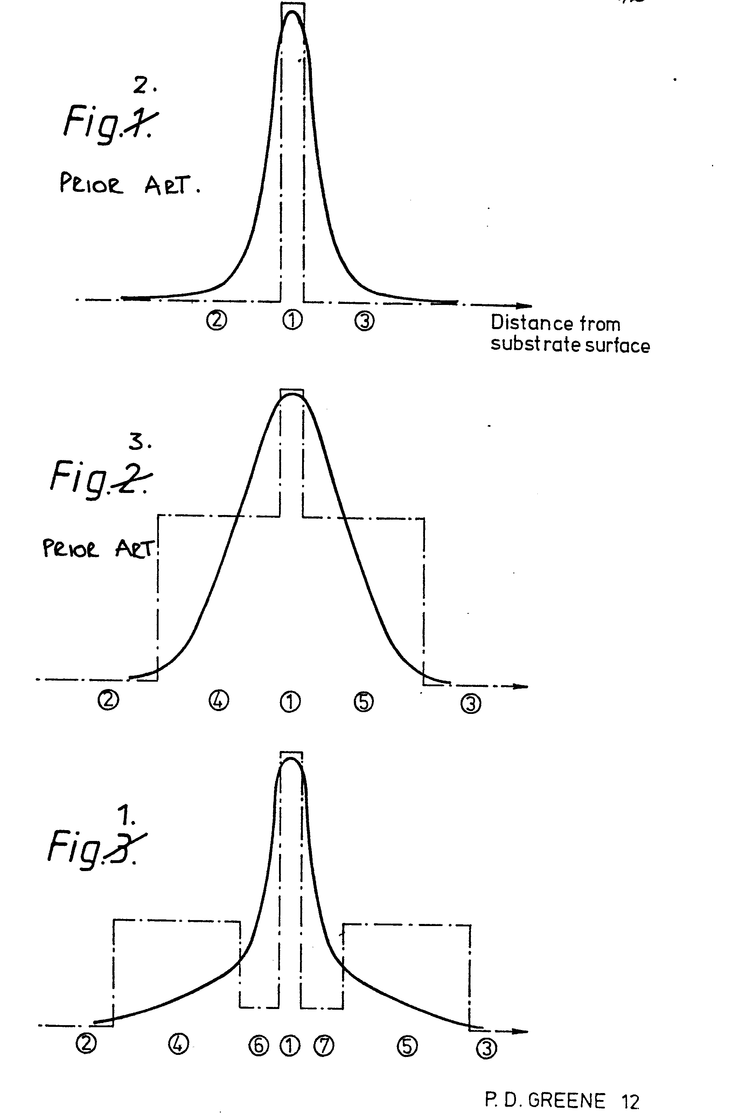

The structure now proposed is illustrated in Fig. 1. It incorporates two further thin layers of low refractive index 6, 7 adjacent to the active layer 1. The light distribution is thereby changed from the roughly triangular shape of Fig. 3 to a shape approaching an inverted T as shown in Fig. 1. This light distribution is advantageous because it combines fairly good confinement within the active layer with a wide spread of light which is not so confined. Consequently the far field can be narrowed to 25° FWHM or less, without demanding an excessive increase in the gain per unit volume within the active layer.

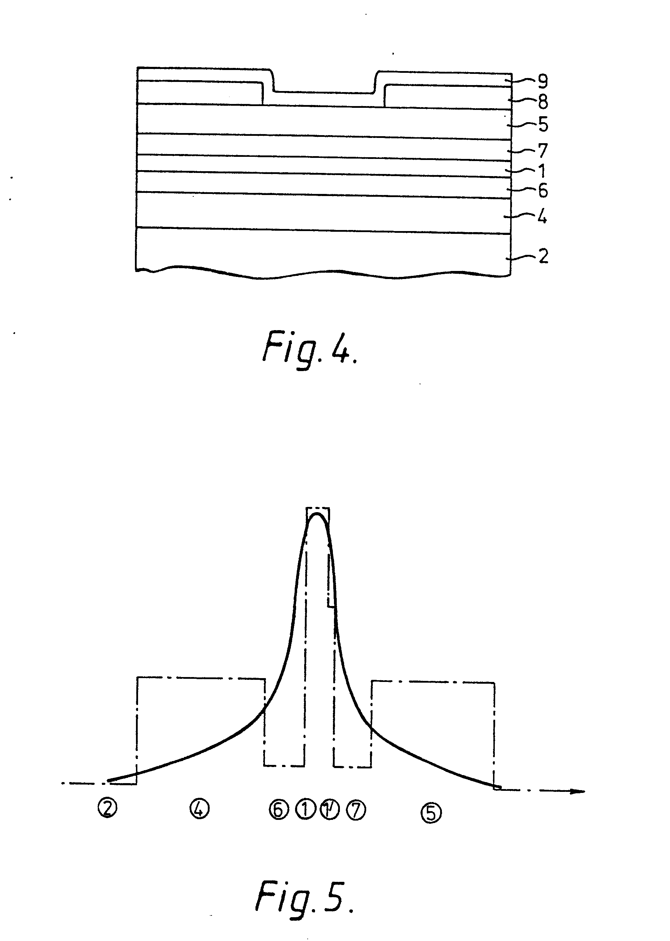

Fig. 4 illustrates a cross-section through the multi-layer structure of an embodiment of semiconductor laser incorporating the refractive index structure of Fig. 3. Upon an n-type structure 2 is disposed an n-type intermediate refractive index layer 4; on layer 4 is disposed an n-type low refractive index layer 6; on layer 6 is disposed the high refractive index active layer 1; on layer 1 is disposed a p-type low refractive index layer 7; on layer 7 is disposed a p-type intermediate refractive index layer 5; on layer 5 is disposed a silicon dioxide layer 8, a metal contact 9 being in contact with layer 5 via a window in the silicon dioxide layer 8. This layer structure may be provided in various different types of lasers e.g. Mesa, MTBH (Mass Transport Buried Heterostructure) DCPBH (Double Channel Planar Buried Heterostructure) in order to produce a narrowed far field. For simplicity the layer structure so far described are symmetrical structures, however asymmetrical structures are also possible, a specific example of the parameters of an asymmetrical structure with an optimised refractive index structure is quoted in Table I. The usual epitaxial layer sequence in semiconductor lasers provides a decrease in refractive index from the active layer outwards. The present invention employs inverse refractive index steps and has been termed IRIS (inverse refractive index step)structure. The symmetric structure has a W-shaped refractive index profile. In dependence on particular requirements, a low refractive index layer may be included on only one side of the active layer.

Table I

| Layer No. | Conductivity type | Thickness (μm) | Thickness range (μm) | y | n |
|---|---|---|---|---|---|
| 5 | P | 1.0 | 0.8 → 1.6 | 0.20 | 3.245 |
| 7 | P | 0.4 | 0.3 → 0.6 | 0.08 | 3.195 |
| 1 | )undoped | 0.05 | 0.03 → 0.07 | 0.48 | 3.335 |
| 1 | ) | 0.16 | 0.15 → 0.18 | 0.85 | 3.455 |
| 6 | n | 0.4 | 0.3 → 0.6 | 0.08 | 3.195 |
| 4 | n | 3.0 | 2.0 → 4.0 | 0.02 | 3.245 |
| 2 | n-substrate | - | - | 0 | 3.160 |

Table I quotes layer thicknesses, range limits therefor, y values and refractive index (n) values for a particular layer structure. The substrate is InP and the active layer of InGaAsP of the general formula $In_{1-x}Ga_xAs_yP_{1-y}$ where y = 2.16x for lattice matching to InP. Associated with active layer 1 is an anti-melt-back layer 1' of a composition intermediate those of layers 1 and 7 so that the refractive index profile is as indicated in Fig. 5, the related light distribution is however substantially unchanged relative to that of Fig. 3. The layer numbers quoted in Table I are those given to the layers in Fig. 4. The anti-melt-back layer 1' is present because the liquid phase epitaxy process does not work satisfactorily when a layer of high y value is followed by one of low y value. The high y layer suffers melt-back. The difficulty is overcome by the intermediate layer 1' which is as thin as practicable. This anti-melt-back layer is a well known technique used when liquid phase epitaxy is the chosen process and when the wavelength exceeds 1.4µm, implying y for the active layer 1 over 0.75. The anti-melt-back layer is only there to assist fabrication; it has no useful function when the laser is working. The anti-melt-back layer is unnecessary when other (e.g. vapour phase epitaxy) processes are selected for growing the structure or when smaller reductions in y are desired.

Whereas it is not so illustrated in Figs 1,4 and 5, a conventional cap layer may also be incorporated in the laser structure of the present invention. A cap layer with an intermediate composition and therefore an intermediate refractive index is a common way of achieving a low contact resistance. Such a cap layer is sufficiently remote (over 1 µm) from the active layer for it to have a negligible effect on the optical properties of the central region where the active layer and the light are to be found. If such a cap layer is provided in the structure of Fig.4 two additional layers between

- 7 - **0177141**

layers 5 and 8 are required, first a layer 3 (Fig. 1) of low refractive index, as structure 2, on layer 5 and then a cap layer of intermediate refractive index on layer 3.

CLAIMS:-

1.    A semiconductor laser characterised by a layer structure including an active layer (1), a first layer (5) for confining light to the active layer (1) and a further layer (7), the further layer (7) being disposed between the active layer (1) and the first light confining layer (5), the refractive index of the first light confining layer (3) being less than that of the active layer (1) and the refractive index of the further layer (7) being less than that of the first light confining layer (5).

2.    A semiconductor laser as claimed in claim 1 characterised in that a second light confining layer (4) is disposed on the opposite side of the active layer (1) to said first light confining layer (5), a respective further layer (6) being disposed between the active layer (11) and the second light confining layer (4).

3.    A semiconductor laser as claimed in claim 2 characterised by an InP substrate (2) with the active layer (1), the first and second light confining layers (4,5) and the two further layers (6,7) being comprised of InGaAsP.

4.    A semiconductor laser as claimed in anyone of claims 1 to 3 characterised by a cap layer, of a refractive index intemediate that of the active layer (1) and the further layer (7), spaced apart from the active layer (1) whereby to have a negligible effect on the optical properties of the active (1), first and further (7) layers and to achieve a low contact resistance.

0177141 1/2

Fig.1.
2.
PRIOR ART.

Distance from substrate surface

② ① ③

Fig.2.
3.
PRIOR ART

② ④ ① ⑤ ③

Fig.3.
1.

② ④ ⑥ ① ⑦ ⑤ ③

P. D. GREENE 12

Fig. 4.

Fig. 5.